Europäisches Patentamt

European Patent Office

Office européen des brevets

(11) Veröffentlichungsnummer: **0 106 790**
**B1**

(12) **EUROPÄISCHE PATENTSCHRIFT**

(45) Veröffentlichungstag der Patentschrift:
**29.06.88**

(21) Anmeldenummer: **83710060.1**

(22) Anmeldetag: **06.09.83**

(51) Int. Cl.⁴: **G 01 R 31/08, H 02 H 7/26**

(54) **Verfahren und Ausführungsanordnung zur Lokalisierung einer Fehlerstelle in einer dreiphasigen Starkstromleitung.**

(30) Priorität: **14.09.82  SE 8205235**

(43) Veröffentlichungstag der Anmeldung:
**25.04.84 Patentblatt 84/17**

(45) Bekanntmachung des Hinweises auf die Patenterteilung:
**29.06.88 Patentblatt 88/26**

(84) Benannte Vertragsstaaten:
**CH DE FR GB IT LI**

(56) Entgegenhaltungen:
**GB-A-2 036 478**

**Patent Abstracts of Japan Band 4, Nr. 110, 8. August
1980, Seite 34P22; & JP-A-55-66768
Patent Abstracts of Japan Band 4, Nr. 55, 24. April
1980, Seite 145P8; & JP-A-55-26465
PROC. IEE, Band 17, Nr. 2, February 1970 W.D.
HUMPAGE et al. "Measuring accuracy of distance
protection with particular reference to earth-fault
conditions on 400kV looped-circuit
interconnections", Seiten 431-438**

(73) Patentinhaber: **ASEA AB, S-721 83 Västeras (SE)**

(72) Erfinder: **Murari, Mohan Saha, Dr., Bangatan 33 B,
S-722 28 Västeras (SE)**

(74) Vertreter: **Boecker, Joachim, Dr.- Ing.,
Rathenauplatz 2-8, D-6000 Frankfurt a.M. 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren gemäß dem Oberbegriff des Anspruches 1 sowie eine Anordnung zur Durchführung dieses Verfahrens.

Ein solches Verfahren zur Lokalisierung einer Fehlerstelle ist bekannt aus der GB-A- 2 036 478. Gemäß diesem bekannten Verfahren wird eine Fehlerstelle vermutet, und unter vereinfachten Annahmen hinsichtlich der Parameter des Netzes werden Strom und Spannung an der Fehlerstelle bestimmt. Wenn dieser Strom und diese Spannung nicht phasengleich sind, so wird eine andere Fehlerstelle vermutet und die Berechnung wiederholt. Dies wird so lange fortgesetzt, bis eine Phasenübereinstimmung des ermittelten Stromes und der ermittelten Spannung vorliegt. Es wird angenommen, daß die zuletzt vermutete Fehlerstelle die wirkliche Fehlerstelle ist. Bei einer Variante dieses Verfahrens wird angenommen, daß die Verteilungsfaktoren für die auf beiden Seiten der Fehlerstelle liegenden Teile des Netzes dasselbe Argument haben, oder daß der Unterschied zwischen den Argumenten bekannt und längs dem aktuellen Leistungsabschnitt konstant ist. Es hat sich gezeigt, daß diese vereinfachte Vermutung zu großen Fehlern bei der Berechnung des Fehlerabstandes führt. Der Unterschied zwischen den beiden genannten Argumenten variiert nämlich mit dem Fehlerabstand, und auch kleine Veränderungen oder Fehler dieses Unterschiedes wirken sich stark auf den berechneten Fehlerabstand aus.

Bei einer anderen Variante des in der genannten englischen Patentanmeldung beschriebenen Verfahrens werden bestimmte Initialwerte sowohl für den genannten Argumentenunterschied als auch für den Fehlerabstand angenommen, wonach Strom und Spannung in der Fehlerstelle berechnet werden. Wenn diese beiden Größen nicht in Phase liegen, werden neue Werte für den Argumentunterschied und den Fehlerabstand angenommen. Dieses Verfahren wird so lange fortgesetzt, bis der Fehlerstrom und die Fehlerspannung in Phase liegen. Man nimmt an, daß der zuletzt angenommene Wert des Fehlerabstandes der wirkliche Fehlerabstand ist. Es hat sich jedoch gezeigt, daß kleine Veränderungen in dem angenommenen Wert des Argumentenunterschiedes große Veränderungen in dem berechneten Fehlerabstand zur Folge haben, so daß dieses Verfahren daher in vielen Fällen völlig falsche Werte liefert oder überhaupt keine Konvergenz für einen bestimmten Fehlerabstand ergibt.

Die genannte englische Patentanmeldung beschreibt das Verfahren anhand eines einphasigen Netzes und deutet die Möglichkeit seiner Verwendung bei einem Drehstromnetz nur an. Es hat sich jedoch gezeigt, daß die obengenannten Nachteile des bekannten Verfahrens bei Drehstromnetzen derart groß sind, daß das Verfahren bei Drehstromnetzen praktisch nicht anwendbar ist.

Ein weiterer Nachteil des bekannten Verfahrens besteht darin, daß das dort angewendete iterative Berechnungsverfahren viel Zeit und/oder eine große Rechnerkapazität erfordert.

Der Erfindung liegt die Aufgabe zugrunde, ein Verfahren nebst Durchführungsanordnung der eingangs genannten Art zu entwickeln, das eine schnelle und sichere Bestimmung des Fehlerabstandes ermöglicht.

Die Lösung dieser Aufgabe gelingt bei einem Verfahren nach dem Oberbegriff des Anspruches 1 erfindungsgemäß durch die im kennzeichnenden Teil des Anspruches 1 genannten Merkmale.

Vorteilhafte Ausgestaltungen des Verfahrens nach der Erfindung sind in den Ansprüchen 2 bis 4 genannt.

Eine Anordnung zur Durchführung des Verfahrens nach der Erfindung ist gemäß der Erfindung durch die im Anspruch 5 genannten Merkmale gekennzeichnet.

Vorteilhafte Ausgestaltungen dieser Anordnung sind in den Ansprüchen 6 und 7 genannt.

Anhand der Figuren soll die Erfindung näher erläutert werden. Es zeigen

Fig. 1 das Prinzip der Anordnung des Fehlerlokalisators an dem einen Ende eines Leitungsabschnittes,

Fig. 2 ein fehlerbehaftetes Drehstromnetz mit vielen der in der folgenden Beschreibung verwendeten Bezeichnungen,

Fig. 3 die Verhältnisse auf der Leitung beim Vorliegen eines Fehlers,

Fig. 4 in Fig. 3 vorkommende Größen in Vektordarstellung,

Fig. 5 die Verbindung von Mitkomponenten-, Gegenkomponenten- und Nullkomponentennetz bei einphasigem Erdschluß,

Fig. 6 die Verbindung von Mitkomponenten- und Gegenkomponentennetz bei einem mehrphasigen Fehler,

Fig. 7 ein Beispiel für den Anschluß eines Fehlerlokalisators an einen vorhandenen Leitungsschutz,

Fig. 8 ein Blockschaltbild eines Ausführungsbeispieles eines Fehlerlokalisators,

Fig. 9 ein Blockschaltbild zur Erläuterung des Arbeitsablaufes des Mikroprozessors,

Fig. 10 die Arbeitsweise des Fehlerlokalisators in Gestalt eines Programmablaufplans.

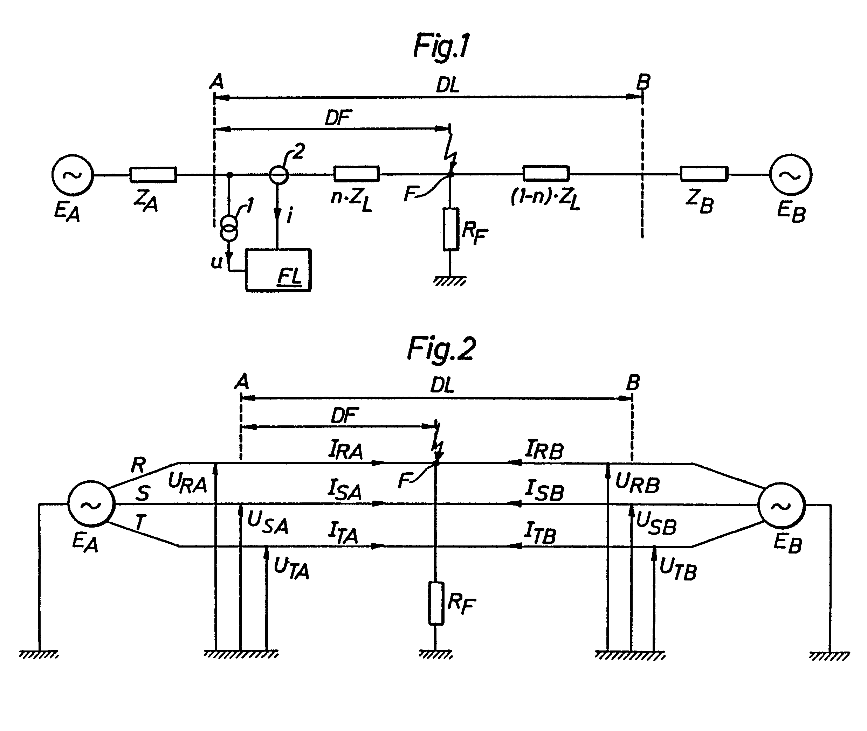

Figur 1 zeigt schematisch einen zu überwachenden Leitungsabschnitt in einem dreiphasigen Starkstromnetz. Der Abschnitt hat die Länge DL und erstreckt sich zwischen den Leitungspunkten A und B. Der Fehlerlokalisator FL ist im Punkt A angeordnet und an die Leitung über Spannungs- und Stromwandler 1 und 2 angeschlossen, welche Meßsignale u und i an den Fehlerlokalisator geben, die den Spannungen und Strömen im Punkt A proportional sind. Der Leitungsabschnitt hat die Impedanz $Z_L$. Ein Fehler beliebiger Art tritt im Punkte F in unbekanntem Abstand DF vom Punkt A auf. Mit $n = \frac{DF}{DL}$ beträgt die Leitungsimpedanz zwischen den Punkten A und F $n \cdot Z_L$ und zwischen den Punkten F und B $(1-n) \cdot Z_L$. Das links von A liegende, "dahinterliegende" Netz hat eine Quellen-EMK $E_A$ und eine Impedanz $Z_A$. Das rechts von B liegende, "davorliegende" Netz hat eine Quellen-EMK $E_B$ und eine Impedanz $Z_B$.

$Z_L$ ist eine bekannte Größe. $Z_A$ kann bekannt sein oder aus gemessenen Strom- und Spannungswerten vor und nach dem Auftreten eines Fehlers im Punkt A berechnet werden. $Z_B$ kann eine bekannte Größe sein, oder

2

$Z_B$ kann mit genügender Genauigkeit geschätzt und im Fehlerlokalisator eingestellt werden. Beim Auftreten eines Fehlers startet der Fehlerlokalisator und berechnet aus gemessenen Strom- und Spannungswerten im Punkt A vor und nach dem Auftreten des Fehlers sowie aus im voraus eingestellten oder berechneten Werten für die Größen $Z_A$, $Z_B$, $Z_L$ den unbekannten Abstand DF oder den relativen Abstand n vom Punkt A bis zur Fehlerstelle F.

Nachstehend sollen die mathematischen Grundlagen für die von dem Fehlerlokalisator ausgenutzten Zusammenhänge erläutert werden.

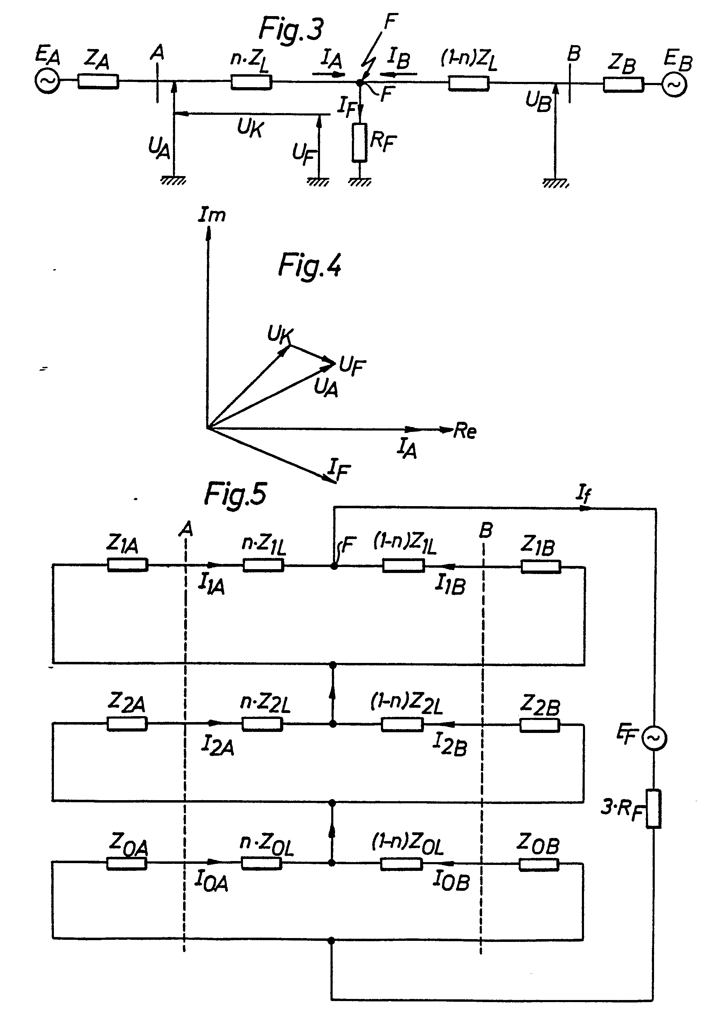

Die Figuren 2 und 3 zeigen die verwendeten Bezeichnungen für Ströme und Spannungen (siehe auch Anlage 1). Figur 4 zeigt in Form eines Vektordiagramms ein Beispiel für die Größen in Figur 3.

Vom Meßpunkt A ausgehend, wird eine Gleichung mit komplexen Größen aufgestellt, welche den Zusammenhang zwischen gemessenen betriebsfrequenten Spannungen und Strömen und den Netzimpedanzen beschreibt. Dadurch, daß der Laststrom vor dem Auftreten des Fehlers gemessen wird, kann der Fehler eliminiert werden, der durch die Ferneinspeisung (die Einspeisung von dem davorliegenden Netz $E_B$, $Z_B$) in die Fehlerstelle entsteht.

Die Gleichung kann generell wie folgt geschrieben werden (siehe Figur 3)

$$U_A = I_A \cdot n \cdot Z_L + I_F \cdot R_F \text{ oder} \tag{1}$$

$$U_A = U_K + U_F, \tag{2}$$

wobei die Werte $U_A$, $I_A$ und $I_F$ von der Art des Fehlers abhängen. Es können zwei Fehlerarten vorkommen, einerseits einphasige Fehler (einphasige Erdschlüsse) und andererseits mehrphasige Fehler (Fehler zwischen zwei oder drei Phasen sowie zwei- oder dreiphasige Erdschlüsse). Nachstehend wird gezeigt, wie $U_A$, $I_A$ und $I_F$ für jede der beiden Fehlerarten abgeleitet werden.

## A. Einphasige Fehler

Diese Fehler werden nachstehend RN, SN, TN genannt. Es wird angenommen, daß die Fehlerart RN (Erdschluß der Phase R) vorliegt. Aus Figur 2 erhält man:

$$U_{RA} = (I_{RA} + KNL \cdot I_{NA}) \cdot n \cdot Z_L + I_F \cdot R_F, \tag{3}$$

wobei $KNL = \frac{Z_{0L} - Z_L}{3 Z_L}$ und $I_F = I_{RA} + I_{RB}$.

Die Stromänderung infolge des Fehlers beträgt $\Delta I_{RA} = I_{RA} - I_{RA}^{\circ}$, $\tag{4}$
wobei $I_{RA}$ der gemessene Strom während des FehLers und $I_{RA}^{\circ}$ der gemessene Strom vor Eintritt des Fehlers ist. Ferner gilt:

$$\Delta I_{RA} = I_{1A} + I_{2A} + I_{0A}, \tag{5}$$

wobei $I_{1A}$, $I_{2A}$ und $I_{0A}$ die symmetrischen Komponenten von $\Delta I_{RA}$ sind. Bekanntlich läßt sich ein unsymmetrisches dreiphasiges Zeigersystem zerlegen in ein symmetrisches rechtsläufiges Mitsystem, ein symmetrisches linksläufiges Gegensystem und ein aus drei phasengleichen (oder um 180° gegeneinander verschobenen) Zeigern bestehendes Nullsystem. Diese drei Teilsysteme werden als die "symmetrischen Komponenten" (Mit-, Gegen- und Nullkomponenten) bezeichnet.

Figur 5 zeigt, wie die Impedanznetze der drei Komponenten auf bekannte Weise verbunden werden. Es gilt der folgende Zusammenhang:

$$\Delta I_{RA} = (D_{1A} + D_{2A} + D_{0A}) \cdot I_f, \tag{6}$$

wobei $D_{1A} = \frac{(1-n) \cdot Z_{1L} + Z_{1B}}{Z_{1A} + Z_{1L} + Z_{1B}}$ und $I_f = \frac{I_f}{3}$.
Entsprechende Ausdrücke gelten für $D_{2A}$ und $D_{0A}$.
Aus Figur 5 erhält man

$$I_f = I_{0A} + I_{0B} = I_{0A} \left(1 + \frac{I_{0B}}{I_{0A}}\right) = I_{0A} \left(1 + \frac{D_{0B}}{D_{0A}}\right).$$

Für $D0_A + D_{0B} = 1$ ergibt sich dabei

$$I_f = \frac{D_{0A}}{D_{0A}}. \tag{7}$$

Aus (7) erhält man

$$I_{NA} + I_{NB} = 3(I_{0A} + I_{0B}) = 3 \cdot I_f = 3\frac{I_{0A}}{D_{0A}}, \tag{8}$$

wobei $I_{NA}$ und $I_{NB}$ die Ströme in dem Nulleiter in den Punkten A bzw. B sind.

Aus (6) und (7) erhält man

$$\Delta I_{RA} = (D_{1A} + D_{2A} + D_{0A}) \cdot I_f = (D_{1A} + D_{2A} + D_{0A}) \cdot \frac{I_{0A}}{D_{0A}} =$$

$$(D_{1A} + D_{2A} + D_{0A}) \cdot \frac{I_{NA}}{3 \cdot D_{0A}}, \tag{9}$$

wobei $I_{NA} = 3 \cdot I_{0A}$. Aus (9) erhält man

$$\frac{I_{NA}}{D_{0A}} = \frac{3 \cdot \Delta I_{RA} - I_{NA}}{D_{1A} + D_{2A}}. \tag{10}$$

Bei Erdschluß kann die Berechnungsgenauigkeit dadurch wesentlich erhöht werden, daß die unsicheren Nullkomponenten eliminiert werden, so daß die Berechnung mit Hilfe der genauer definierten Mitkomponenten des Netzes vorgenommen werden kann.

Aus (3) und (8) erhält man

$$I_F = 3 \cdot I_f = I_{RA} + I_{RB} = I_{NA} + I_{NB} = \frac{I_{NA}}{D_{0A}} \tag{11}$$

Aus (10) und (11) erhält man

$$I_F = \frac{3 \cdot \Delta I_{RA} - I_{NA}}{D_{1A} + D_{2A}} \tag{12}$$

Es kann angenommen werden, daß die Verteilungsfaktoren für den Mitkomponenten- und Gegenkomponentenstrom mit guter Genauigkeit gleich sind, d.h.

$$D_{1A} = D_{2A} = \frac{(1-n)Z_L + Z_B}{Z_A + Z_L + Z_B} \tag{13}$$

(12) und (13) geben einen Ausdruck für $I_F$, ausgedrückt in meßbaren Größen:

$$I_F = \frac{I_{FA}}{D_{1A}}, \tag{14}$$

wobei $I_{FA} = \frac{3}{2} \cdot (\Delta I_{RA} - I_{0A})$ und $I_{0A} = \frac{I_{NA}}{3}$.

Aus (3) und (14) erhält man

$$U_{RA} = (I_{RA} + KNL \cdot I_{NA}) \cdot n \cdot Z_L + \frac{3}{2} \cdot \frac{(\Delta I_{RA} - I_{0A})}{D_{1A}} \cdot R_F \tag{15}$$

Dieser Ausdruck kann in folgende allgemeine Form umgeschrieben werden:

$$U_A = I_A \cdot n \cdot Z_L + I_{FA} \cdot \frac{r_F}{D_{1A}}, \tag{16}$$

wobei $U_A = U_{RA}$, $I_A = I_{RA} + KNL \cdot I_{NA}$ und

$$I_{FA} = \frac{3}{2}(\Delta I_{RA} - I_{0A}) = \frac{3}{2}(\Delta I_{RA} - \frac{I_{NA}}{3}).$$

Die Gleichung (16) ist die allgemeine Form einer Fehlerlokalisierungsgleichung (vgl. Gleichung (1)), wobei die Werte für $U_A$, $I_A$ und $I_{FA}$ für jede Fehlerart verschieden sind. Diese Werte gehen aus Anlage 2 für die drei einphasigen Fehlerarten RN, SN und TN hervor.

## B. Mehrphasige Fehler

Diese Fehlerarten sind nachstehend mit RS, ST, TR für zweiphasige Fehler (Fehler zwischen zwei Phasen), mit RST für dreiphasige Fehler und mit RSN, STN und TRN für zweiphasige Erdschlüsse (Doppelerdschluß) bezeichnet. Es wird angenommen, daß ein zweiphasiger Fehler zwischen den Phasen R und S vorliegt. Für mehrphasige Fehler werden Hauptspannung und Differenzströme bei der Berechnung verwendet.

Aus Figur 2 folgt:

$$U_{RA} - U_{SA} = (I_{RA} - I_{SA}).n.Z_L + [(I_{RA} - I_{SA}) + (I_{RB} - I_{SB})] \cdot R_7 \tag{17}$$

d.h.

$$U_{RSA} = I_{RSA} \cdot n \cdot Z_L + (I_{RSA} + I_{RSB}) \cdot R_F \tag{18}$$

bei Verwendung der Bezeichnungen gemäß Anlage 1.

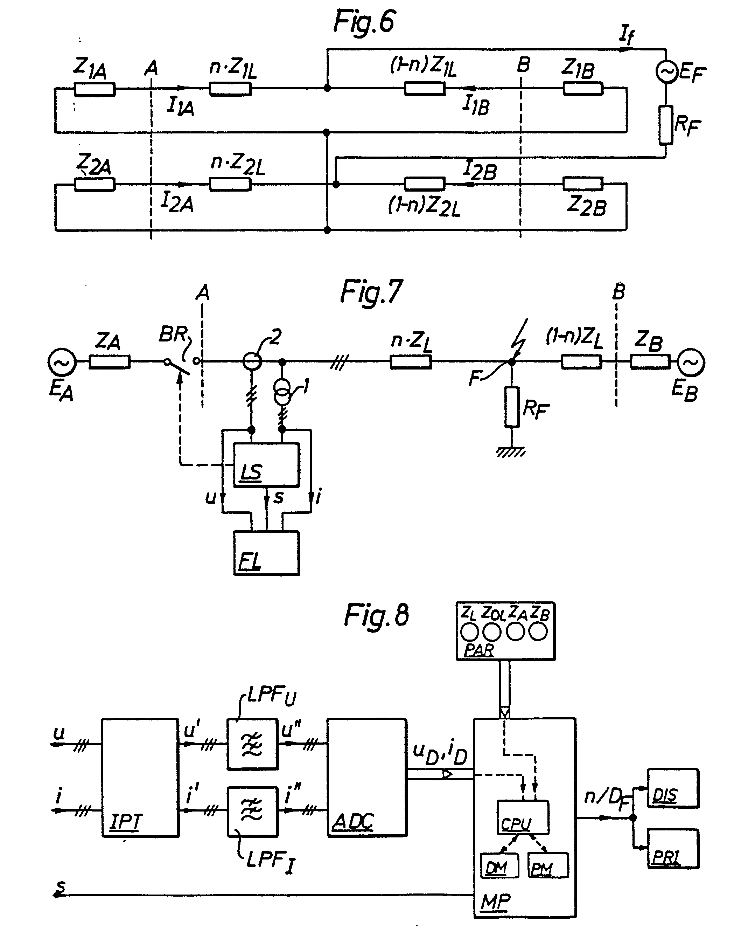

Figur 6 zeigt die Verbindung des Mitkomponentennetzes mit dem Gegenkomponentennetz bei dieser Fehlerart. Unter Bezugnahme auf Figur 6 kann folgende Gleichung aufgestellt werden:

$$I_{RA} = (a^2 \cdot I_{1A} + a \cdot I_{2A} + a^2 \cdot I_b) \cdot a = I_{1A} + a^2 \cdot I_{2A} + I_b$$

d.h.

$$I_{RA} = I_{1A} + a^2 \cdot I_{2A} + I_{RA}^\circ, \tag{19}$$

wobei $I_{1A}$ der Mitkomponentenstrom im Punkt A ist,

$I_{2A}$ der Gegenkomponentenstrom im Punkt A ist,

$I_b = I_{RA}^\circ$ der vor Eintritt des Fehlers gemessene Strom ist,

$a = \frac{1}{2} + j \cdot \frac{\sqrt{3}}{2}$ und $a^2 = -\frac{1}{2} - j \cdot \frac{\sqrt{3}}{2}$.

Aus (19) erhält man

$$\Delta I_{RA} = I_{RA} - I_{RA}^\circ = I_{1A} + a^2 \cdot I_{2A} \tag{20}$$

Die Verteilungsfaktoren für das Mitkomponenten- und das Gegenkomponentennetz können mit guter Genauigkeit gleich gesetzt werden, d.h.

$$D_{1A} = D_{2A} = \frac{(1-n) \cdot Z_L + Z_B}{Z_A + Z_L + Z_B}, \text{ so daß}$$

$$I_{1A} = -I_{2A}. \tag{21}$$

Aus (20) und (21) erhält man

$$\Delta I_{RA} = I_{RA} - I_{RA}^\circ = I_{1A} (1-a^2) \tag{22}$$

Auf gleiche Weise erhält man

$$I_{SA} = (a \cdot I_{1A} + a^2 \cdot I_{2A} + a \cdot I_b) \cdot a = a^2 \cdot I_{1A} + I_{2A} + a^2 \cdot I_b$$

d.h.

$$I_{SA} = a^2 \cdot I_{1A} + I_{2A} + I_{SA}^\circ, \tag{23}$$

wobei $I_{SA}^\circ = a^2 \cdot I_{RA}^\circ$.

Aus den Gleichungen (21) und (23) erhält man

$$\Delta I_{SA} = I_{SA} - I_{SA}^\circ = a^2 \cdot I_{1A} + I_{2A} = I_{1A} (a^2 - 1) \tag{24}$$

Die Gleichungen (22) und (24) ergeben

$$\Delta I_{RSA} = \Delta I_{RA} - \Delta I_{Sa} = I_{1A} \cdot (1-a^2 - a^2 + 1)$$

d.h.

$$\Delta I_{RSA} = 2 I_{1A} (1-a^2) \tag{25}$$

Ferner gilt (Fig. 6)

$$I_{1A} = D_{1A} \cdot I_f \tag{26}$$

woraus zusammen mit Gleichung (25) folgt:

$$\Delta I_{RSA} = 2 \cdot D_{1A} \cdot I_f (1-a^2) \tag{27}$$

Aus den Gleichungen (19) und (23) erhält man

$$I_{RA} - I_{SA} = 2 \cdot (1-a^2) \cdot I_{1A} + I_b (1-a^2) \tag{28}$$

Auf gleiche Weise erhält man den folgenden Ausdruck für den Differenzstrom zwischen Phase R und Phase S im Punkt B:

$$I_{RB} - I_{SB} = 2 \cdot (1-a^2) \cdot I_{1B} - I_b (1-a^2) \tag{29}$$

woraus zusammen mit der Gleichung (28) folgt:

$$(I_{RA} - I_{SA}) + (I_{RB} - I_{SB}) = 2 \cdot (1-a^2) \cdot (I_{1A} + I_{1B}). \tag{30}$$

Ferner gilt (Figur 6)

$$I_{1B} = D_{1B} \cdot I_f, \tag{31}$$

wobei $D_{1B} = \frac{n \cdot Z_L + Z_A}{Z_A + Z_L + Z_B}$ und

$$D_{1A} + D_{1B} = 1 \tag{32}$$

Aus den Gleichungen (26), (30), (31) und (32) erhält man

$$(I_{RA} - I_{SB}) + (I_{RB} - I_{SB}) = 2 \cdot (1-a^2) \cdot I_f \tag{33}$$

Gleichung (27) kann wie folgt geschrieben werden

$$I_f = \frac{\Delta I_{RSA}}{2 \cdot D_{1A} (1-a^2)} \tag{34}$$

und ergibt mit der Gleichung (33):

$$(I_{RA} - I_{SA}) + (I_{RB} - I_{SB}) = \frac{\Delta I_{RSA}}{D_{1A}} \tag{35}$$

Auf gleiche Weise wie bei einphasigen Fehlern wird der Fehlerstrom $I_F$ in meßbaren Größen ausgedrückt:

$$I_F = I_{RSA} + I_{RSB} = \frac{I_{FA}}{D_{1A}}, \tag{36}$$

wobei $I_{FA}$ die durch den Fehler verursachte Stromänderung im Punkt A ist und folgenden Wert hat:

$I_{FA} - \Delta I_{RSA}.$
Aus den Gleichungen (18) und (36) erhält man

$$U_{RSA} = I_{RSA} \cdot n \cdot Z_L + \Delta I_{RSA} \cdot \frac{R_F}{D_{1A}} \tag{37}$$

Auf gleiche Weise, wie bei einem Einphasenfehler (Gleichung 16) kann diese Gleichung in folgende allgemeine Form umgeschrieben werden:

$$U_A = I_A \cdot n \cdot Z_L + I_{FA} \cdot \frac{R_F}{D_{1A}}, \tag{38}$$

wobei $U_A = U_{RSA} = U_{RA} - U_{SA}$, $I_A = I_{RSA} = I_{RA} - I_{SA}$ und

$$I_{FA} = \Delta I_{RSA} = I_{RSA} - I_{RSA}{}^0 = (I_{RA} - I_{RA}{}^0) - (I_{SA} - I_{SA}{}^0).$$

Gleichung (38) ist ebenso wie Gleichung (16) die allgemeine Form der Fehlerlokalisierungsgleichung, wobei die Werte für $U_A$ und $I_{FA}$ für jede Fehlerart verschieden sind. Diese Werte gehen aus Anlage 2 für die mehrphasigen Fehlerarten RS, ST, TR, RSN, STN, TRN und RST hervor.

## C. Lösung der Fehlerlokalisierungsgleichung

Die Gleichung, die komplexe Variable und Parameter enthält, hat, wie vorstehend erwähnt, die Form

$$U_A = I_A \cdot n \cdot Z_L + I_{FA} \cdot \tfrac{R_F}{D_{1A}} \tag{39}$$

Da $D_{1A}$ (Gleichung 13) eine lineare Funktion von n ist, ist Gleichung (39) nichtlinear und kann wie folgt geschrieben werden:

$$n^2 - n \cdot K_1 + K_2 - K_3 \cdot R_F = 0, \tag{40}$$

wobei

$$K_1 = \tfrac{U_A}{I_A \cdot Z_L} + 1 + \tfrac{Z_B}{Z_L}$$

$$K_2 = \tfrac{U_A}{I_A \cdot Z_L} (\tfrac{Z_B}{Z_L} + 1) \tag{41}$$

$$K_3 = \tfrac{I_{FA}}{I_A \cdot Z_L} \cdot [\tfrac{Z_A + Z_B}{Z_L} + 1]$$

Die Werte für $U_A$, $I_A$ und $I_{FA}$ sind dabei aus lokal im Punkt A gemessenen Strömen und Spannungen gemäß Anlage 2 berechenbar. Die Leitungsimpedanz $Z_L$ ist eine bekannte Größe. $Z_A$ ist die äquivalente Impedanz des dahinterliegenden Netzes. Sie ist entweder bekannt oder kann geschätzt oder aus vor und nach Eintritt des Fehlers gemessenen Strömen und Spannungen berechnet werden. $Z_B$ ist die äquivalente Impedanz des davorliegenden Netzes; sie ist entweder bekannt oder kann geschätzt oder berechnet werden.

Die Real- und Imaginärteile der komplexen Faktoren $K_1$, $K_2$ und $K_3$ können wie folgt geschrieben werden:

$$K_1 = K_{1H} + j \cdot K_{1V}$$

$$K_2 = K_{2H} + j \cdot K_{2V} \tag{42}$$

$$K_3 = K_{3H} + j \cdot K_{3V}$$

Indem man die komplexe Gleichnung (40) in Real- und Imaginärteil aufteilt, erhält man zwei Gleichungen, durch welche die unbekannte Fehlerresistanz $R_F$ eliminiert werden kann. Man erhält die folgende reelle, direkt lösbare quadratische Gleichung für n:

$$n^2 + B \cdot n + C = 0, \tag{43}$$

wobei

$$B = \tfrac{K_{1V} \cdot K_{3H} - K_{1H} \cdot K_{3V}}{K_{3V}} \text{ und } C = \tfrac{K_{2H} \cdot K_{3V} - K_{2V} \cdot K_{3H}}{K_{3V}}$$

Als Lösung der Gleichung (43) erhält man folgende beide Wurzeln

$$n_1 = \tfrac{-B + \sqrt{B^2 - 4C}}{2} \text{ und } n_2 = \tfrac{-B - \sqrt{B^2 - 4C}}{2}, \tag{44}$$

wobei diejenige Wurzel gewählt wird, welche die bedingung $[0 \leqq n \leqq 1]$ erfüllt.

Figur 7 zeigt ein Beispiel dafür, wie der Fehlerlokalisator FL gemäß der Erfindung an einen Leitungsabschnitt A - B über einen Leitungsschutz LS angeschlossen werden kann. Hierbei kann es sich beispielsweise um einem Leitungsschutz des Typs handeln, wie er in dem "RAZFE Application Guide No. 61-12 AG" der Firma ASEA AB beschrieben wird. Dieser Schutz und der Fehlerlokalisator werden über die Spannungs- und Stromwandler 1 und 2 mit Meßwerten für die Phasenströme und -spannungen der Leitung gespeist. Bei einem Fehler in dem Abschnitt A-B gibt der Leitungsschutz ein Signal s an den Fehlerlokalisator. Dieses Signal veranlaßt einerseits die Berechnung des Abstandes zum Fehler durch den Fehlerlokalisator und enthält andererseits eine Angabe darüber, um welche der in Anlage 2 genannten Fehlerarten es sich handelt. Die Fehlerart bestimmt nämlich, wie aus der vorstehenden Beschreibung des Berechnungsvorgangs hervorgeht, welche Größen bei der Lösung der Fehlergleichung verwendet werden.

Der Leitungsschutz gibt bei Bedarf auch ein Auslösesignal an einen Schalter BR (Fig. 7).

Der Fehlerlokalisator kann mit allen Arten von Leitungsschutzvorrichtungen kombiniert werden, die phasenselektive Startkontakte haben.

Alternativ kann der Fehlerlokalisator mit eigenen Gliedern zum Start und zur Bestimmung der Fehlerart versehen und dann direkt an die Leitung angeschlossen werden, wie es in Figur 1 gezeigt ist.

Figur 8 zeigt das Blockschaltbild eines Ausführungsbeispiels des Fehlerlokalisators. Die Meßsignale u und i, die aus den drei Phasenspannungen bzw. Phasenströmen im Punkt A bestehen, werden einer Transformatoreinheit IPT zugeführt, die Isoliertransformatoren mit elektrostatischen Schirmen enthält, die einen Schutz gegen transiente Ausgleichsvorgänge bieten und eine Anpassung des Signalniveaus an die folgende Elektronik vornehmen. Die Ausgangssignale u' und i' der Transformatoreinheit werden in Tiefpaßfiltern LPF$_U$ und LPF$_I$, beispielsweise mit der Grenzfrequenz 500 Hz, gefiltert. Die gefilterten Signale u'' und i'' werden einem Analog-Digitalwandler ADC zugeführt. In diesem wird jedes Eingangssignal fortlaufend kurzfristig abgetastet (gemessen), z. B. 24 mal pro Periode. Die auf diese Weise in digitale Form umgewandelten Meßwerte u$_D$, i$_D$ werden einem Mikroprozessor MP zugeführt. Dieser enthält eine Zentraleinheit CPU, welche folgende Funktionen ausführt:

Einsammlung der Meßwerte

Bearbeitung der Meßwerte

Berechnung des Fehlerabstandes

Ausgabe des Berechnungsergebnisses

Rückkehr zur normalen Messung nach

einem Leitungsfehler.

Der Mikroprozessor MP enthält außerdem einen Datenspeicher DM sowie einen Programmspeicher PM.

Der Fehlerlokalisator enthält ferner Parametereinstellvorrichtungen PAR zur Einstellung der komplexen Werte der Leitungsparameter (z. B. Z$_L$, Z$_{OL}$, Z$_A$, Z$_B$). Schließlich ist eine Wiedergabeeinheit DIS vorhanden, z. B. in Form eines Leuchtdiodendisplays oder eines Schreibers PRI.

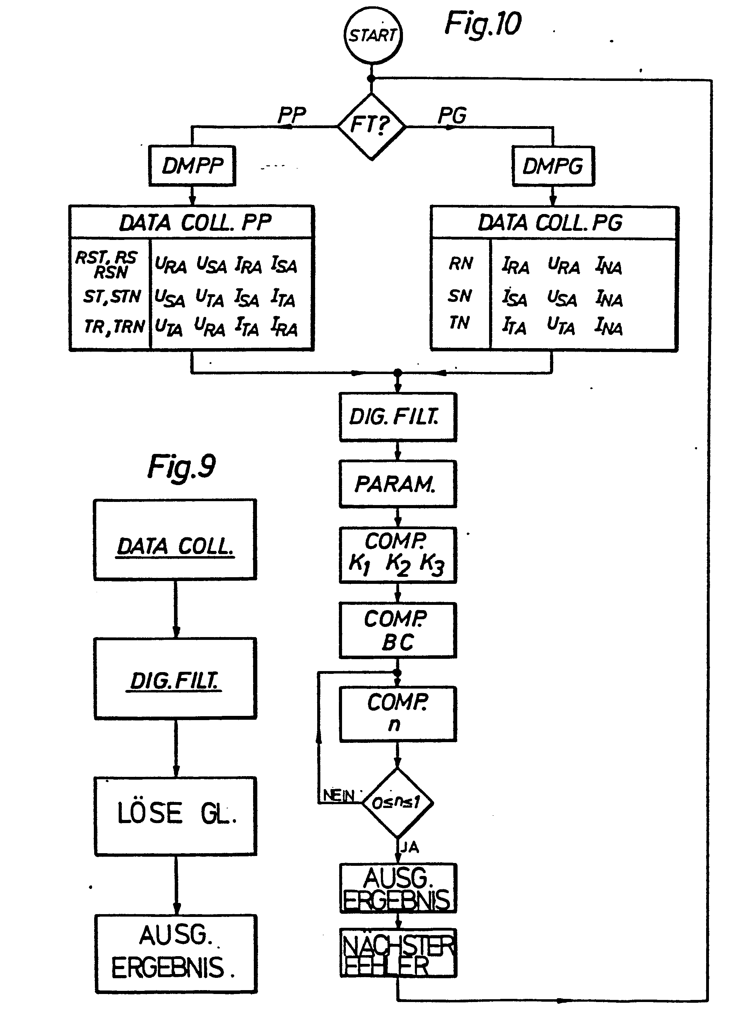

Die Funktion des Fehlerlokalisators soll anhand des Blockschaltbildes in Figur 9 beschrieben werden. Das Glied DATA COLL. bezeichnet die Meßwerteinsammlung. Diese findet fortlaufend bei ungestörtem Betrieb statt. Die vom Analog-Digitalwandler gelieferten digitalen Meßwerte werden im Speicher DM derart gespeichert, daß dieser Speicher stets die Meßwerte für die letzten Perioden erhält, z. B. für die letzten sechs Perioden. Wie bereits festgestellt, erfolgt diese Art der Speicherung fortlaufend bei ungestörtem Betrieb. Sie wird jedoch etwa eine Periode nach dem Auftreten eines Leitungsfehlers von dem Startsignal s des Leitungsschutzes unterbrochen. In dem Speicher DM sind dann die Meßwerte eines Zeitintervalls vor Eintritt des Fehlers und eines Zeitintervalls nach Eintritt des Fehlers gespeichert.

Beim Vorliegen eines Fehlers tastet der Fehlerlokalisator auch die Kontaktstellung der phasenselektiven Startrelais des Leitungsschutzes ab, wodurch die Fehlerart definiert ist.

Wenn die Meßwerteinsammlung unterbrochen worden ist, erfolgt ein digitales Filtern (DIG.FILT) derjenigen der gespeicherten Meßsignale, die (siehe Anlage 2) bei der Abstansberechnung verwendet werden. Das Filtern eines Meßsignals geht so vor sich, daß die Vektoren der betriebsfrequenten Grundwelle aus dem Meßsignal entnommen werden. Das digitale Filtern kann in der in "IEEE Tutorial Course" 79 EHO148-7-PWR, Chapter III, Seiten 16-23 beschriebenen Weise erfolgen.

Nach diesem Filtern setzt der Mikroprozessor die komplexen Werte der aktuellen Meßwerte und Parameter ein und bestimmt in der oben beschriebenen Weise die Konstanten B und C in der Gleichung (43), die danach mit Hilfe einer einfachen Quadratwurzelmethode (Glied LÖSE G1) gelöst wird. Der so erhaltene Wert für den Fehlerabstand wird danach an das Wiederabgabegerät DIS und eventuell vorhandene Schreiber PRI gegeben (Glied AUSG.ERGEBNIS).

Figur 10 zeigt den Programmablaufplan für das Programm, das die Arbeitsweise des Fehlerlokalisators bei einem Leitungsfehler steuert. Zuerst wird die Fehlerart (FT?) aus der vom Leitungsschutz gelieferten Information bestimmt und im Datenspeicher gespeichert. Dies ist symbolisch als DMPG (einphasige Fehler PG) bzw. DMPP (mehrphasiger Fehler PP) dargestellt. Anhand der Information über die Fehlerart werden danach die gespeicherten Werte der für die aktuelle Fehlerart erforderlichen Meßsignale in Übereinstimmung mit den Angaben in den Blöcken DATA COLL.PP bzw. DATA COLL.PG abgelesen. Diese Meßsignale werden danach in der oben genannten Weise gefiltert (DIG.FILT). Die im voraus eingestellten, geschätzten oder berechneten Werte der Netzparameter werden dann abgelesen (PARAM). Die Konstanten K$_1$, K$_2$ und K$_3$ werden aus der Gleichung (41) berechnet, und danach werden die in der Gleichung (43) auftretenden Konstanten B und C berechnet. Danach wird der relative Fehlerabstand n aus dieser Gleichung (siehe Gleichung 44) bestimmt, und nach der im Anschluß an die Lösung der Gleichung (44) oben beschriebenen logischen Entscheidung erhält man den Wert für n, der an das Wiedergabegerät usw. gegeben wird (AUSG. ERGEBNIS).

Hiernach - eventuell nach einer manuellen Rückstellun-geht der Fehlerlokalisator wieder über zur fortlaufenden Dateneinsammlung und wartet auf den nächsten Fehler, bei dem (Glied NÄCHSTER FEHLER) der oben beschriebene Funktionszyklus wiederholt wird.

Wie aus der vorstehenden Beschreibung der Erfindung hervorgeht, hat diese gegenüber bekannten Verfahren und Anordnungen wesentliche Vorteile.

Die beim Erdschluß auftretenden Nullkomponenten werden gemäß der Erfindung eliminiert, und bei der Berechnung werden nur die Mitkomponenten verwendet. Die Nullkomponenten sind mit einer relativ großen Ungenauigkeit behaftet, und da nur die gut definierten Mitkomponenten verwendet werden, wird die Genauigkeit bei der Fehlerlokalisierung erheblich erhöht.

Gemäß der Erfindung werden außerdem alle Verzerrungen der Grundwellenkomponente in den Meßwerten eliminiert, wodurch Fehler in der Abstandsbestimmung aufgrund von Gleichstromoder Gleichspannungskomponenten und Oberwellen vollständig beseitigt werden.

Ferner wird gemäß der Erfindungg ein vollständiges Netzmodell verwendet, wobei auf korrekte Weise die Einspeisung (I$_B$) von dem davorliegenden Netz (E$_B$, Z$_B$) berücksichtigt wird. Es hat sich nämlich gezeigt, daß diese Berücksichtigung von großer Bedeutung ist, um eine Fehlerlokalisierung unter allen Umständen schnell und sicher durchführen zu können und den Fehlerabstand mit großer Genauigkeit berechnen zu können.

In vielen Betriebsfällen ist es von großer Bedeutung, die Fehlerlokalisierung schnell durchzuführen. Wie oben beschrieben wurde, erhält man gemäß der Erfindung den Fehlerabstand auf einfache Weise dadurch, daß die Konstanten einer quadratischen Gleichung aus den Meßwerten errechnet werden und die quadratische Gleichung durch eine einfache Quadratwurzelmethode gelöst wird. Diese direkte Methode ermöglicht bei entsprechender Berechnungskapazität eine bedeutend schnellere Abstandsbestimmung als die bekannten iterativen Verfahren.

Das Verfahren und die Anordnung nach der Erfindung ergeben außerdem mit ein und derselben Berechnungsmethode eine korrekte und genaue Fehlerabstandsbestimmung für alle bei einer Drehstromleitung möglichen Fehlerarten.

Dadurch, daß die direkte Lösungsmethode nach der Erfindung bei gleichen Leistungsansprüchen eine erheblich kleinere Berechnungskapazität als eine iterative Methode erfordert, ist eine Anordnung nach der Erfindung wesentlich einfacher und billiger, als ein mit entsprechender Schnelligkeit arbeitender iterativer Fehlerlokalisator.

**Bezeichnungen**

| | |
|---|---|
| $E_A$ | EMK des dahinterliegenden Netzes |
| $E_B$ | EMK des davorliegenden Netzes |
| $U_A$ | allgemeine Bezeichnung für Spannung im Punkte A |
| $U_B$ | allgemeine Bezeichnung für Spannung im Punkte B |
| $I_A$ | allgemeine Bezeichnung für Strom im Punkte A |
| $I_B$ | allgemeine Bezeichnung für Strom im Punkte B |
| $U_{RA}, U_{SA}, U_{TA}$ | Phasenspannungen im Punkt A |
| $U_{RB}, U_{SB}, U_{TB}$ | Phasenspannungen im Punkt B |
| $I_{RA}, I_{SA}, I_{TA}$ | Phasenströme im Punkt A |
| $I_{RB}, I_{SB}, I_{TB}$ | Phasenströme im Punkt B |
| $I_{NA}, I_{NB}$ | Ströme in Nulleitern im Punkt A und B |
| $U_{RSA}, U_{STA}, U_{TSA}$ | Verkettete Spannungen im Punkt A, z. B. ($U_{RSA} = U_{RA} - U_{SA}$) |
| $U_{RSB}, U_{STB}, U_{TRB}$ | Verkettete Spannungen im Punkt B |
| $I_{RSA}$ | Differenzstrom zwischen Phase B und Phase S im Punkt A ($I_{RSA} = I_{RA} - I_{SA}$) |
| $I_{RSB}$ | Differenzstrom zwischen Phase R und Phase S im Punkt B ($I_{RSB} = I_{RB} - I_{SB}$) |
| $U_{RA}{}^\circ, I_{RA}{}^\circ, I_{SA}{}^\circ, I_{TA}{}^\circ$ | Gemessene Größe vor Eintritt des Fehlers |
| $U_k$ | Spannungsfall zwischen Punkt A und der Fehlerstelle |
| $\Delta I_{RA}$ | Stromänderung infolge eines Fehlers ($\Delta I_{RA} = I_{RA} - I_{RA}{}^\circ$) |
| $I_{1A}, I_{2A}, I_{0A}$ | Mitkomponenten- Gegenkomponenten und Nullkomponentenströme im Punkt A |
| $I_{1B}, I_{2B}, I_{0B}$ | Mitkomponenten- Gegenkomponenten und Nullkomponentenströme im Punkt B |
| $I_b$ | Gemessener Laststrom vor Eintritt des Fehlers ($I_b = I_{RA}{}^\circ$) |
| $E_F$ | Spannung an der Fehlerstelle vor Eintritt des Fehlers |

$$E_F = \frac{E_A - E_B}{Z_{1L} + Z_{1A} + Z_{1B}} \cdot (Z_{1A} + n \cdot Z_{1L})$$

| | |
|---|---|
| $U_F$ | Spannung an der Fehlerstelle |
| $I_F$ | Strom in der Fehlerstelle |
| $I_f$ | Strom in der Fehlerstelle bei Berechnung mit symmetrischen Komponenten ($I_f = \frac{I_F}{3}$) |
| $I_{FA}$ | Von $I_F$ verursachte Stromveränderung im Punkt A |
| | ($I_{FA} = D_{1A} \cdot I_F$) |
| $Z_A$ | Quellenimpedanz des dahinterliegenden Netzes |
| $Z_B$ | Quellenimpedanz des davorliegenden Netzes |
| $Z_{1L}, Z_{2L}, Z_{0L}$ | Mitkomponente-, Gegenkomponente- und Nullkomponente der Leitungsimpedanz ($Z_L = Z_{1L} = Z_{2L}$) |
| $Z_L$ | Impedanz des Leitungsabschnittes |
| $Z_{1A}, Z_{2A}, Z_{0A}$ | Mitkomponente-,Gegenkomponente- und Nullkomponente von $Z_A$ ($Z_A = Z_{1A} = Z_{2A}$) |
| $Z_{1B}, Z_{2B}, Z_{0B}$ | Mitkomponente-, Gegenkomponente- und Nullkomponente von $Z_B$ ($Z_B = Z_{1B} = Z_{2B}$) |
| $D_{1A}, D_{2A}, D_{0A}$ | Verteilungsfaktoren für das Mitkomponenten-, Gegenkomponenten und Nullkomponentennetz im Punkt A |
| $D_{1B}, D_{2B}, D_{0B}$ | Verteilungsfaktoren für das Mitkomponenten-, Gegenkomponenten- und Nullkomponentennetz im Punkt B |
| KNL | Nullkomponentenkompensation (KNL $= \frac{Z_{0L} - Z_L}{3 Z_L}$) |
| $R_F$ | Fehlerresistanz |
| DL | Länge des Leitungsabschnittes |
| DF | Abstand zwischen Punkt A und der Fehlerstelle |
| n | relativer Fehlerabstand ($n = \frac{DF}{DL}$) |
| $a, a^2$ | $a = \frac{1}{2} + j\frac{\sqrt{3}}{2} \quad a^2 = \frac{1}{2} - j\frac{\sqrt{3}}{2}$ |
| $K_1, K_2, K_3$ | Komplexe Faktoren der Gleichung $n^2 - n \cdot K_1 + K_2 - K_3 \cdot R_F = 0$ |
| $K_{1H}$ | Realteil von $K_1$ |
| $K_{1V}$ | Imaginärteil von $K_1$ |
| B, C | Konstanten in der Gleichung $n^2 + Bn + C = 0$. |

**Bei verschiedenen Fehlerarten gültige Werte für $U_A$, $I_A$, $I_{FA}$**

| Fehler-art | $U_A$ | $I_A$ | $I_{FA}$ |
|---|---|---|---|
| RN | $U_{RA}$ | $I_{RA} + KNL \cdot I_{NA}$ | $\frac{1}{2}[3(I_{RA} - I_{RA}^0) - I_{NA}]$ |
| SN | $U_{SA}$ | $I_{SA} + KNL \cdot I_{NA}$ | $\frac{1}{2}[3(I_{SA} - I_{SA}^0) - I_{NA}]$ |
| TN | $U_{TA}$ | $I_{TA} + KNL \cdot I_{NA}$ | $\frac{1}{2}[3(I_{TA} - I_{TA}^0) - I_{NA}]$ |
| RST RS RSN | $U_{RA} - U_{SA}$ | $I_{RA} - I_{SA}$ | $(I_{RA} - I_{RA}^0) - (I_{SA} - I_{SA}^0)$ |
| ST STN | $U_{SA} - U_{TA}$ | $I_{SA} - I_{TA}$ | $(I_{SA} - I_{SA}^0) - (I_{TA} - I_{TA}^0)$ |
| TR TRN | $U_{TA} - U_{RA}$ | $I_{TA} - I_{RA}$ | $(I_{TA} - I_{TA}^0) - (I_{RA} - I_{RA}^0)$ |

## Patentansprüche

1. Verfahren zur Lokalisierung einer Fehlerstelle (F) in einem zwischen einem dahinterliegenden ($E_A$, $Z_A$) und einem davorliegenden ($E_B$, $Z_B$) Netz liegenden Leitungsabschnitt (AB) einer dreiphasigen Starkstromleitung, bei welchem die Ströme und Spannungen ($U_A$, $I_A$) der Leitung an einer an dem einen Ende (A) des Leitungsabschnitts liegenden Meßstelle gemessen werden und anhand der Meßwerte und der bekannten Parameter ($Z_L$) des Leitungsabschnitts der Abstand zwischen der Meßstelle und der Fehlerstelle berechnet wird, dadurch gekennzeichnet, daß beim Auftreten eines Fehlers zunächst bestimmt wird, ob es sich um einen einphasigen oder einen mehrphasigen Fehler handelt, daß die Meßwerte zur Gewinnung ihrer Grundwellenanteile gefiltert werden und daß in Abhängigkeit der ermittelten Fehlerart aus den komplexen Werten der Grundwellenanteile der Meßwerte, der Impedanz des Leitungsabschnitts und den im voraus eingestellten oder berechneten Werten der Impedanzen ($Z_A$, $Z_B$) des davorliegenden und des dahinterliegenden Netzes der Fehlerabstand (n) nach der Gleichung

$$n^2 + B\,n + C = 0$$

berechnet wird, in welcher diejenige Lösung (Wurzel) den Fehlerabstand (n) beschreibt, die zwischen Null und Eins liegt, in welcher die Parameter (B,C) von den Grundwellenanteilen der Meßwerte und den genannten Impedanzen abhängig sind und welche unter Eliminierung der Fehlerresistanz ($R_F$) gebildet wird.

2. Verfahren nach Anspruch 1, dadurch gekennzeichnet, daß die Grundwellenanteile der Meßwerte als komplexe Größen durch digitale Filter der Meßwerte gebildet werden.

3. Verfahren nach Anspruch 1 oder 2, dadurch gekennzeichnet, daß nur die Mitkomponenten der Impedanzen des davorliegenden und des dahinterliegenden Netzes bei der Bestimmung des Fehlerabstandes verwendet werden.

4. Verfahren nach einem der vorhergehenden Ansprüche, dadurch gekennzeichnet, daß die Gleichung mit Hilfe einer direkten, nichtiterativen Methode gelöst wird.

5. Anordnung zur Durchführung des Verfahrens nach einem der vorhergehenden Ansprüche zur Lokalisierung einer Fehlerstelle (F) in einem zwischen einem dahinterliegenden ($E_A$, $Z_A$) und einem davorliegenden ($E_B$, $Z_B$) Netz liegenden Leitungsabschnitt (AB) einer dreiphasigen Starkstromleitung mit Meßgliedern (1, 2) zur Messung der Strom- und Spannungswerte der Leitung an einem Ende (A) des Leitungsabschnitts und mit Berechnungsgliedern (MP), die aus den gemessenen Strom- und Spannungswerten sowie aus der bekannten Impedanz ($Z_L$) des Leitungsabschnitts den Abstand (n) zwischen der Meßstelle und der Fehlerstelle zu berechnen vermögen, dadurch gekennzeichnet, daß Geräte ($LPF_U$, $LPF_I$, MP) zum Filtern der Meßwerte und zur Bestimmung der Grundwellenanteile dieser Meßwerte als komplexe Größen vorhanden sind und daß die Berechnungsglieder (MP) derart beschaffen sind, daß sie in Abhängigkeit der ermittelten Fehlerart aus den komplexen Werten der Grundwellenanteile der Meßwerte, der Impedanz des Leitungsabschnitts und den im voraus eingestellten oder berechneten Werten der Impedanzen ($Z_A$, $Z_B$) des davorliegenden und des dahinterliegenden Netzes der Fehlerabstand (n) nach der Gleichung

$$n^2 + B\,n + C = 0$$

berechnet, in welcher diejenige Lösung (Wurzel) den Fehlerabstand (n) beschreibt, die zwischen Null und Eins liegt, in welcher die Parameter (B, C) von den Grundwellenanteilen der Meßwerte und den genannten Impedanzen abhängig sind und welche unter Eliminierung der Fehlerresistanz ($R_F$) gebildet wird.

6. Anordnung nach Anspruch 5, <u>dadurch gekennzeichnet,</u> daß sie Glieder (PAR) zur Voreinstellung der komplexen Werte der Impedanz ($Z_L$) des Leitungsabschnitts und eventuell der Impedanzen ($Z_A$, $Z_B$) des davor- und des dahinterliegenden Netzes enthält.

7. Anordnung nach Anspruch 5 oder 6, <u>dadurch gekennzeichnet,</u> daß die Berechnungsglieder derart angeordnet sind, daß sie aus der Gleichung (43) mit Hilfe einer Quadratwurzelmethode den Fehlerabstand (n) zu bestimmen vermögen.

## Claims

1. Method for locating a fault point (F) within a line section (AB) of a three-phase power transmission line located between a network ($E_A$, $Z_A$) positioned behind said section and a network ($E_B$, $Z_B$) positioned ahead of said section, wherein currents and voltages ($U_A$, $I_A$) on the line are measured at a measuring point at one end (A) of the line section and the distance between the measuring point and the fault point is calculated from said measuring values and the known parameters ($Z_L$) of the line section, <u>characterized</u> in that, when a fault occurs, it is at first determined whether the fault is of a single-phase or a multi-phase type, that the measuring values are filtered for obtaining their fundamental wave portions, and that in dependence on the fault type detected the fault distance (n) is calculated from the complex values of the fundamental wave portions of the measuring values, the impedance of the line section, and the pre-set or calculated values of the impedances ($Z_A$, $Z_B$) of the ahead-positioned and the behind-positioned network according to the equation

$$n^2 + B n + C = 0$$

wherein that solution (root) determines the fault distance (n) the value of which is between zero and one, wherein the parameters (B, C) are dependent on the fundamental wave portions of the measuring values and said impedances, and which equation has been formed by eliminating the fault resistance ($R_F$).

2. Method according to Claim 1, <u>characterized</u> in that the fundamental wave portions of the measuring values are formed as complex quantities by digital filtering of the measuring values.

3. Method according to Claim 1 or 2, <u>characterized</u> in that only the positive sequence components of the impedances of the ahead-positioned and the behind-positioned network are used for determining the fault distance.

4. Method according to any of the preceding Claims, <u>characterized</u> in that the equation is solved by means of a direct non-iterative method.

5. Device for carrying out the method according to any of the preceding claims for locating a fault point (F) within a line section (AB) of a three-phase power transmission line located between a network ($E_A$, $Z_A$) positioned behind said section and a network ($E_B$, $Z_B$) positioned ahead of said section, with measuring members (1,2) for measuring the current and voltage values of the line at one end (A) of the line section and with calculating members (MP) adapted to calculate the distance (n) between the measuring point and the fault point from the measured current and voltage values and the known impedance ($Z_L$) of the line section, <u>characterized</u> in that there are devices ($LPF_U$, $LPF_I$, MP) for filtering the measuring values and for determining the fundamental wave portions of these measuring values as complex quantities, and that the calculating members (MP) are adapted such as to calculate the fault distance (n) in dependence on the fault type detected from the complex values of the fundamental wave portions of the measuring values, the impedance of the line section and the pre-set or calculated values of the impedances (ZA, ZB) of the ahead-positioned and the behind-positioned network according to the equation

$$n^2 + B n + C = 0$$

wherein that solution (root) determines the fault distance (n) the value of which is between zero and one, wherein the parameters (B, C) are dependent on the fundamental wave portions of the measuring values and said impedances, and which equation has been formed by eliminating the fault resistance ($R_F$).

6. Device according to Claim 5, <u>characterized</u> in that it comprises members (PAR) for pre-setting the complex values of the impedance ($Z_L$) of the line section and possibly the impedances ($Z_A$, $Z_B$) of the ahead-positioned and the behind-positioned network.

7. Device according to any of Claims 5 or 6, <u>characterized</u> in that the calculating members are arranged such as to calculate the fault distance (n) from the equation (43) with the aid of the square root method.

## Revendications

1. Procédé pour localiser un défaut (F) dans une section de ligne (AB), d'une ligne triphasée à courant fort, située entre un réseau aval ($E_A$, $Z_A$) et un réseau amont ($E_B$, $Z_B$), procédé dans lequel les courants et les tensions ($I_A$, $U_A$) de la ligne sont mesurés en un poste de mesure qui est situé à une extrémité (A) de ladite section de ligne, et dans lequel on calcule, à l'aide des valeurs de mesure et des paramètres connus ($Z_L$) de la section de ligne, la distance entre le poste de mesure et l'emplacement où se situe le défaut, caractérisé en ce que, lors de l'apparition d'un défaut, on détermine tout d'abord s'il s'agit d'un défaut monophasé ou polyphasé, que les valeurs de mesure sont filtrées pour l'obtention de leurs composantes d'onde fondamentale, et que, en fonction du type de défaut déterminé, on calcule, à partir des valeurs complexes, des composantes d'onde fondamentale des valeurs de mesure, de l'impédance de la section de ligne et des valeurs, introduites à l'avance ou calculées, des impédances ($Z_A$, $Z_B$) des réseaux amont et aval, la distance de défaut (n) au moyen de l'équation:

$$n^2 + Bn + C = 0,$$

dans laquelle la solution (racine) qui indique la distance du défaut (n), est celle qui se situe entre zéro et un, dans laquelle les paramètres (B, C) sont fonction des composantes d'onde fondamentale des valeurs de mesure et desdites impédances, la solution étant formée par élimination de la résistance du défaut ($R_F$).

2. Procédé selon la revendication 1, caractérisé en ce que les composantes d'onde fondamentale des valeurs de mesures sont formées en grandeurs complexes par filtrage numérique des valeurs de mesures.

3. Procédé selon la revendication 1 ou 2, caractérisé en ce qu'on utilise, lors de la détermination de la distance du défaut, uniquement les composantes directes des impédances des réseaux situés en amont et en aval.

4. Procédé selon l'une des revendications précédentes, caractérisé en ce que l'équation est résolue à l'aide d'une méthode directe, non itérative.

5. Dispositif pour la mise en oeuvre du procédé selon l'une des revendications précédentes, pour localiser un défaut (F) dans une section de ligne (AB), d'une ligne triphasée à courant fort, située entre un réseau aval ($E_A$, $Z_A$) et un réseau amont ($E_B$, $Z_B$), dispositif qui comporte des unités de mesure (1, 2), à une extrémité (A) de la section de ligne, pour mesurer les valeurs du courant et de la tension de la ligne, et des unités de calcul (MP), qui peuvent calculer, à partir des valeurs du courant et de la tension mesurées, ainsi que des impédances ($Z_L$) connues de la section de ligne, la distance (n) entre le poste de mesure et l'emplacement du défaut, caractérisé en ce que sont prévus des appareils ($LPF_U$, $LPF_T$, MP) destinés à filtrer les valeurs de mesure et à déterminer, en grandeurs complexes, les composantes d'onde fondamentale de ces valeurs de mesure, et que les unités de calcul (MP) sont constituées de manière à ce qu'en fonction du type de défaut déterminé, elles calculent, à partir des valeurs complexes, des composantes d'onde fondamentale des valeurs de mesure, de l'impédance de la section de ligne, et des valeurs, introduites à l'avance ou calculées, des impédances ($Z_A$ $Z_B$) des réseaux situés en amont et en aval, la distance du défaut (n) au moyen de l'équation

$$n^2 + Bn + C = 0,$$

dans laquelle la solution (racine) qui indique la distance du défaut (n) est celle qui se situe entre zéro et un, dans laquelle les paramètres (B, C) sont fonction des composantes d'onde fondamentale des valeurs de mesure et desdites impédances, la solution étant formée par élimination de la résistance du défaut ($R_F$).

6. Dispositif selon la revendication 5, caractérisé en ce qu'il contient des éléments (PAR) destinés à préintroduire les valeurs complexes de l'impédance ($Z_L$) de la section de ligne, et éventuellement des impédances ($Z_A$, $Z_B$) du réseau situé en amont et du réseau situé en aval.

7. Dispositif selon la revendication 5 ou 6, caractérisé en ce que l'unité de calcul est agencée de manière à ce qu'elle puisse déterminer à partir de l'équation (43), la distance du défaut (n), à l'aide d'une méthode à racine carrée.

*Fig.1*

*Fig.2*

*Fig.3*

*Fig.4*

*Fig.5*

## Fig.6

## Fig.7

## Fig.8

5

0 106 790

Fig.10

Fig.9

START

FT?

PP    PG

DMPP    DMPG

**DATA COLL. PP**

| RST, RS RSN | $U_{RA}$ | $U_{SA}$ | $I_{RA}$ | $I_{SA}$ |
|---|---|---|---|---|
| ST, STN | $U_{SA}$ | $U_{TA}$ | $I_{SA}$ | $I_{TA}$ |
| TR, TRN | $U_{TA}$ | $U_{RA}$ | $I_{TA}$ | $I_{RA}$ |

**DATA COLL. PG**

| RN | $I_{RA}$ | $U_{RA}$ | $I_{NA}$ |
|---|---|---|---|
| SN | $I_{SA}$ | $U_{SA}$ | $I_{NA}$ |
| TN | $I_{TA}$ | $U_{TA}$ | $I_{NA}$ |

DIG. FILT.

PARAM.

COMP. $K_1$ $K_2$ $K_3$

COMP. BC

COMP. n

NEIN    $0 \leq n \leq 1$    JA

AUSG. ERGEBNIS

NÄCHSTER FEHLER

DATA COLL.

DIG. FILT.

LÖSE GL.

AUSG. ERGEBNIS.

7